# EUROPEAN PATENT APPLICATION

(11) **EP 4 704 498 A1**
(43) Date of publication of application: **04.03.2026**
(21) Application number: 25198688.1
(22) Date of filing: 28.08.2025
(51) Int. Cl.: H05K 1/11, H05K 1/189, H05K 3/00, H05K 1/02, H05K 3/321

(54) **FLEXIBLE PRINTED CIRCUIT BOARD, DISPLAY DEVICE INCLUDING THE FLEXIBLE PRINTED CIRCUIT BOARD, ELECTRONIC DEVICE INCLUDING THE FLEXIBLE PRINTED CIRCUIT BOARD, AND METHOD FOR MANUFACTURING THE DISPLAY DEVICE**

(30) Priority: 02.09.2024 KR 20240118443
(71) Applicant: Samsung Display Co., Ltd., Yongin-si, Gyeonggi-do 17113 (KR)
(72) Inventor: CHO, Youngmin, 17113 Yongin-si (KR); MIN, Jinsic, 17113 Yongin-si (KR); YOUN, Jungsoo, 17113 Yongin-si (KR); JUNG, Changsub, 17113 Yongin-si (KR)
(74) Representative: Walaski, Jan Filip

(57) **Abstract**

A display device includes a display panel, which includes a plurality of panel pads arranged along a first direction, and a flexible printed circuit board. The flexible printed circuit board includes a base portion, a first protrusion protruding in a second direction intersecting a first direction from one side of the base portion extending in the first direction, a second protrusion protruding in the second direction from the one side of the base portion and spaced apart from the first protrusion in the first direction, first connection pads disposed on the first protrusion, and second connection pads disposed on the second protrusion. At least some of the first connection pads extend in a direction inclined with respect to the first direction and the second direction, and at least some of the second connection pads extend in a direction inclined with respect to the first direction and the second direction.

## Description

This application claims priority to Korean Patent Application No. 10-2024-0118443, filed on 2 September 2024.

### BACKGROUND

### 1. Technical Field

The present disclosure relates to a flexible printed circuit board, a display device, an electronic device, and a method for manufacturing a display device. Specifically, the present disclosure relates to a flexible printed circuit board, a display device, an electronic device, and a method for manufacturing a display device, wherein bonding precision during the manufacturing process is improved, and the reliability of the electrical connection is enhanced.

### 2. Description of the Related Art

In general, a display device includes two or more electronic components. For example, display devices such as mobile phones, notebook computers, and televisions include a display panel for displaying images, a flexible printed circuit board, and a main circuit board.

The two electronic components are electrically connected through the connection of pads. The pad portions of the two electronic components may be joined through an alignment step and a pressing process.

The pads of the two electronic components may have dimensions different from the design dimensions due to manufacturing errors. In addition, the two electronic components may shrink or expand due to heat generated during the bonding process. Accordingly, research is being conducted to improve the bonding precision of the electronic components.

### SUMMARY

The present disclosure aims to provide a flexible printed circuit board, a display device, and an electronic device with improved reliability of electrical connection.

Additionally, the present disclosure aims to provide a method for manufacturing a display device with improved reliability of electrical connection.

A display device includes: a display panel including a substrate, with a display area for displaying images and a non-display area defined therein, and a plurality of panel pads disposed in the non-display area and arranged along a first direction; and a flexible printed circuit board including a base portion, a first protrusion protruding in a second direction intersecting the first direction from one side of the base portion extending in the first direction, a second protrusion protruding in the second direction from the one side of the base portion and spaced apart from the first protrusion in the first direction, first connection pads disposed on the first protrusion, and second connection pads disposed on the second protrusion. Each of the first connection pads overlaps and is electrically connected to each of the first panel pads in a plan view, and each of the second connection pads overlaps and is electrically connected to each of the second panel pads in the plan view. At least some of the first connection pads extend in a direction inclined with respect to the first and second directions, and at least some of the second connection pads extend in a direction inclined with respect to the first and second directions.

According to one embodiment of the present disclosure, the flexible printed circuit board may further include at least two or more first alignment marks disposed on the first protrusion and at least two or more second alignment marks disposed on the second protrusion.

According to one embodiment of the present disclosure, the at least two first alignment marks may be disposed facing each other with the first connection pads therebetween in the first direction, and the at least two second alignment marks may be disposed facing each other with the second connection pads therebetween in the first direction.

According to one embodiment of the present disclosure, at least two of the first connection pads may extend in different directions from each other, and at least two of the second connection pads may extend in different directions from each other.

According to one embodiment of the present disclosure, at least two of the first connection pads may be symmetrical with each other about a first axis of symmetry extending in the second direction, and at least two of the second connection pads may be symmetrical with each other about a second axis of symmetry extending in the second direction.

According to one embodiment of the present disclosure, a first pad and a second pad among the first connection pads may be symmetrical with each other about the first axis of symmetry, and a third pad and a fourth pad among the first connection pads may be symmetrical with each other about the first axis of symmetry.

In one embodiment, imaginary lines extending along longitudinal directions of the first connection pads may converge at a first convergence point, and a fifth pad and a sixth pad among the second connection pads may be symmetrical with each other about the second axis of symmetry.

In one embodiment, a seventh pad and an eighth pad among the second connection pads may be symmetrical with each other about the second axis of symmetry, and imaginary lines extending along longitudinal directions of the second connection pads may converge at a second convergence point.

According to one embodiment of the present disclosure, a width of the first protrusion in the first direction may differ from a width of the second protrusion in the first direction.

According to one embodiment of the present disclosure, a total number of the first connection pads may be different from a total number of the second connection pads.

According to one embodiment of the present disclosure, a cutout portion may be defined between the first protrusion and the second protrusion, and a depth of the cutout portion may be 5 millimeters (mm) or greater in the second direction.

According to one embodiment of the present disclosure, the first protrusion and the second protrusion may have a same length in the first direction.

According to one embodiment of the present disclosure, a total number of the first connection pads may be the same as a total number of the second connection pads.

According to one embodiment of the present disclosure, a first distance from one side of the first protrusion extending in the first direction to one side of the display panel overlapping with the first protrusion in the second direction may be different from a second distance from one side of the second protrusion extending in the first direction to one side of the display panel overlapping with the second protrusion in the second direction.

According to one embodiment of the present disclosure, a third distance from ends of the first connection pads close to a side of the first protrusion extending in the first direction to one side of the display panel overlapping with the first protrusion in the second direction may be different from a fourth distance from ends of the second connection pads close to a side of the second protrusion extending in the first direction to one side of the display panel overlapping with the second protrusion in the second direction.

According to one embodiment of the present disclosure, the flexible printed circuit board may further include a third protrusion spaced apart from the second protrusion in the first direction and third connection pads disposed on the third protrusion.

In one embodiment, each of the third connection pads may overlap and be electrically connected to each of the third panel pads in a plan view.

In one embodiment, at least some of the third connection pads may extend in a direction inclined with respect to the first direction and the second direction.

A method for manufacturing a display device according to one embodiment of the present disclosure includes: preparing a display panel including panel pads arranged along a first direction; preparing a flexible printed circuit board including a base portion, a first protrusion protruding in a second direction intersecting the first direction from one side of the base portion extending in the first direction, a second protrusion protruding in the second direction from the one side of the base portion and spaced apart from the first protrusion in the first direction, first connection pads disposed on the first protrusion, and second connection pads disposed on the second protrusion; aligning the flexible printed circuit board on the display panel by adjusting the position of the first protrusion with a first alignment head and adjusting the position of the second protrusion with a second alignment head; preliminarily pressing the display panel and the flexible printed circuit board; and finally pressing the display panel and the flexible printed circuit board.

In one embodiment of the present disclosure, in the preliminarily pressing of the display panel and the flexible printed circuit board, the first connection pads and the first panel pads may be preliminarily pressed using a first preliminary pressing head, and the second connection pads and the second panel pads may be preliminarily pressed using a second preliminary pressing head different from the first preliminary pressing head.

In one embodiment of the present disclosure, in the finally pressing of the display panel and the flexible printed circuit board, the first connection pads and the first panel pads may be finally pressed using a first final pressing head, and the second connection pads and the second panel pads may be finally pressed using a second final pressing head different from the first final pressing head.

A display device according to one embodiment of the present disclosure may include: a display panel including a substrate, with a display area for displaying images and a non-display area defined therein, and a plurality of panel pads disposed in the non-display area and arranged along a first direction; and a flexible printed circuit board including a base portion, a first protrusion protruding in a second direction intersecting the first direction from one side of the base portion extending in the first direction, a second protrusion protruding in the second direction from the one side of the base portion and spaced apart from the first protrusion in the first direction, first connection pads disposed on the first protrusion, and second connection pads disposed on the second protrusion.

In one embodiment, each of the first connection pads may overlap and be electrically connected to each of the first panel pads in a plan view, and each of the second connection pads may overlap and be electrically connected to each of the second panel pads in a plan view.

In one embodiment, the flexible printed circuit board may further include at least two or more first alignment marks disposed on the first protrusion and at least two or more second alignment marks disposed on the second protrusion.

In one embodiment of the present disclosure, at least two of the first connection pads may be symmetrical about a first axis of symmetry extending in the second direction, and at least two of the second connection pads may be symmetrical about a second axis of symmetry different from the first axis of symmetry and extending in the second direction.

In one embodiment of the present disclosure, a distance from one side of the first connection pads to one side of the display panel overlapping with the first protrusion in the second direction may be different from a distance from one side of the second connection pads to one side of the display panel overlapping with the second protrusion in the second direction.

A flexible printed circuit board according to one embodiment of the present disclosure includes: a base portion; a first protrusion protruding in a second direction intersecting a first direction from one side of the base portion extending in the first direction; a second protrusion protruding in the second direction from the one side of the base portion and spaced apart from the first protrusion in the first direction; first connection pads disposed on the first protrusion; and second connection pads disposed on the second protrusion. At least some of the first connection pads may extend in a direction inclined with respect to the first direction and the second direction, and at least some of the second connection pads may extend in a direction inclined with respect to the first direction and the second direction.

An electronic device according to one embodiment of the present disclosure may include the flexible printed circuit board above.

In one embodiment, the electronic device may further include: a display panel comprising a substrate and a plurality of panel pads, wherein the substrate has a display area and a non-display area defined therein, the display area is configured to display an image, and the plurality of panel pads are disposed in the non-display area and arranged along the first direction.

In one embodiment, in a plan view, the first connection pads may overlap with and be electrically connected to first panel pads of the plurality of panel pads, respectively, and in the plan view, the second connection pads may overlap with and be electrically connected to second panel pads of the plurality panel pads, respectively.

According to the present disclosure, by arranging connection pads and alignment marks on each protrusion, the bonding precision between the flexible printed circuit board and the display panel can be improved, and thus it becomes possible to provide a flexible printed circuit board, a display device, an electronic device, and a method for manufacturing a display device with enhanced reliability of electrical connection.

### BRIEF DESCRIPTION OF THE DRAWINGS

These and/or other features will become apparent and more readily appreciated from the following description of the embodiments, taken in conjunction with the accompanying drawings in which:
FIG. 1 is a plan view of a display device;
FIG. 2 is a cross-sectional view of a display device;
FIG. 3 is a cross-sectional view showing a separated portion of the display device ;
FIG. 4 is a cross-sectional view of the display device;
FIG. 5 is a perspective view showing a part of the display device;
FIGS. 6A to 6E are plan views showing separated parts of the display device illustrated in FIG. 1;
FIG. 7 is a plan view showing a part of a display panel;
FIG. 8 is an enlarged view of the AA1 area of FIG. 1;
FIG. 9 is a diagram showing a part of the display device;
FIG. 10 is a diagram showing a part of the display device;
FIG. 11 is a diagram showing a part of the display device;
FIG. 12 is a diagram showing a part of the display device;
FIG. 13 is a plan view showing a part of the display device;
FIG. 14 is a plan view showing a part of the display device;
FIG. 15 is a plan view showing a part of the display device;
FIG. 16 is a plan view showing a part of the display device;
FIG. 17 is a plan view showing a part of the display device;
FIG. 18 is a plan view showing a part of the display device;
FIG. 19 is a plan view showing a part of the display device;
FIG. 20 is a plan view showing a part of the display device;
FIG. 21 is a plan view showing a part of the display device;
FIG. 22 is a plan view showing a part of the display device;
FIG. 23 is a plan view showing a part of the display device;
FIGS. 24A to 24C are perspective views sequentially illustrating a method for manufacturing a display device;
FIG. 25 is a diagram showing electronic devices in which a display device is applied; and
FIG. 26 is a diagram showing electronic devices in which a display device is applied.

### DETAILED DESCRIPTION

References will now be made in detail to certain embodiments, of which examples are illustrated in the accompanying drawings, where like reference numerals refer to like elements throughout. The embodiments may have a variety of forms and permutations, but the present disclosure shall by no means be construed as being limited to the described embodiments. Rather, the present disclosure shall be construed to encompass all forms, permutations, equivalents and substitutes covered by the technical ideas and scope of the present disclosure. Accordingly, the embodiments are merely described below, by referring to the figures, to explain features of the present disclosure.

When an element (or region, layer, portion, etc.) is described to be "disposed on," "placed on," "arranged on," "connected to," or "coupled to" another element, it shall be construed as being disposed on, placed on, arranged on, connected to, or coupled to the other element directly but also as possibly having another element therebetween. On the other hand, if one element is described to be "directly disposed on," "directly placed on," "directly arranged on," "directly connected to," or "directly coupled to" another element, it shall be construed that there is no other element interposed therebetween.

Like or identical reference numerals refer to like or identical elements. Moreover, in the accompanying drawings, the thicknesses, ratios, and dimensions of the elements may not be to exact scale and may have been exaggerated for the benefit of effective explanation of the technical features associated with these elements. As such, the present disclosure shall not be restricted to the thicknesses, ratios, dimensions, etc. illustrated in the drawings.

Terms such as "first" and "second" may be used in describing various elements, but the above elements shall not be restricted to the above terms. The above terms may be used only to distinguish one element from the other. For instance, the first element may be named the second element, and vice versa, without departing the scope of claims of the present disclosure. Unless clearly used otherwise, any expressions in a singular form may include a meaning of a plural form. The term "and/or" shall include the combination of a plurality of listed items or any of the plurality of listed items.

Moreover, relative terms, such as "below," "under," "beneath," "lower," "bottom," "above," "over," "upper," "top," etc., may be used herein to describe one element's relationship to another element as illustrated in the accompanying figures. It shall be understood that relative terms are intended to encompass different orientations of the device in addition to the orientation depicted in the accompanying figures. For example, if the device in one of the figures is turned over, elements described as being on the "lower" side of the other elements would then be oriented on "upper" sides of the other elements. The exemplary term "lower" can therefore encompass an orientation of both "lower" and "upper," depending on the particular orientation of the figure. Similarly, if the device in one of the figures is turned over, elements described as "below" or "beneath" other elements would then be oriented "above" the other elements. The exemplary term "below" or "beneath" can therefore encompass an orientation of both above and below.

An expression such as "comprising" or "including" is intended to designate a characteristic, a number, a step, an operation, an element, a part or combinations thereof, and shall not be construed to preclude any possibility of presence or addition of one or more other characteristics, numbers, steps, operations, elements, parts or combinations thereof.

Unless otherwise defined, all terms, including technical terms and scientific terms, used herein have the same meaning as how they are generally understood by those of ordinary skill in the art to which the present disclosure pertains. Any term that is defined in a general dictionary shall be construed to have the same meaning in the context of the relevant art, and, unless otherwise defined explicitly, shall not be interpreted to have an idealistic or excessively formalistic meaning.

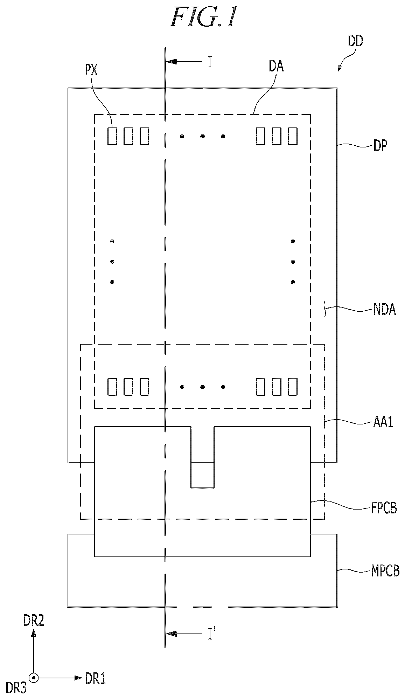

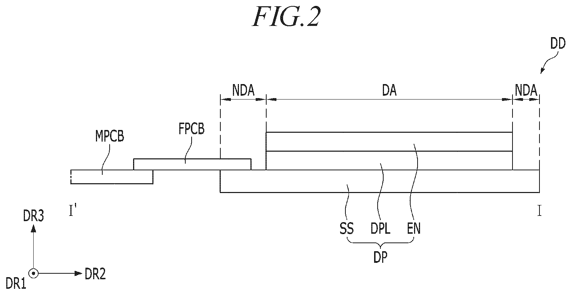

Directions such as first direction DR1, second direction DR2, and third direction DR3 may be defined in the present specification. The first direction DR1 and the second direction DR2 may be directions defined in a plan view of the display device DD shown in FIG. 1 and may intersect each other. The third direction DR3 may be a thickness direction of the display device DD as defined in FIG. 2.

FIG. 1 is a plan view of a display device, and FIG. 2 is a cross-sectional view of the display device. As used herein, the "plan view" is a view in a thickness direction of the display device.

Referring to FIGS. 1 and 2, a display device DD includes a display panel DP and a flexible printed circuit board FPCB coupled to the display panel DP. The display device DD may further include a main circuit board MPCB coupled to the flexible printed circuit board FPCB. The display panel DP, the flexible printed circuit board FPCB, and the main circuit board MPCB may be electrically connected.

The display panel DP has a display area DA and a non-display area NDA surrounding the display area DA. The display area DA may be an area where images are displayed. The non-display area NDA may be an area where images are not displayed. The display area DA may have a plurality of pixels PX, which are configured to render images, arranged therein. The pixels PX may be arranged in a matrix shape along a first direction DR1 and a second direction DR2. The display panel DP may be configured to control the pixels PX to display various images.

Each of the pixels PX may include a display element (not shown) and a driving element (not shown). The display element (not shown) may encompass a variety of embodiments. For example, the display element may be configured as at least one of a liquid crystal capacitor, an organic light-emitting diode, an electrophoretic element, or an electrowetting element. However, this is presented by way of example, and the display element may include various embodiments as long as it is configured to render images based on electrical signals, and it is not limited to any particular embodiment.

The driving element (not shown) may be configured to control the driving of each display element of the pixels PX. The driving element may include a thin-film transistor (not shown). The display panel DP may be configured to be driven by an active method, allowing each pixel PX to be independently controlled.

In the non-display area NDA, a plurality of signal lines (not shown) configured to connect to the pixels PX and a plurality of panel pads (not shown) configured for electrical connection with the flexible printed circuit board FPCB may be arranged. In the non-display area NDA, the display panel DP may be coupled with external electronic components such as the flexible printed circuit board FPCB and configured to be electrically connected.

Referring to FIG. 2, the display panel DP may include a substrate SS, a display layer DPL, and an encapsulation layer EN, which are stacked along a third direction DR3 in cross-section. The substrate SS may either be a single layer or include a plurality of insulating layers. The substrate SS may be at least one of a glass substrate, a plastic substrate, a film, and a laminate including multiple organic and/or inorganic layers, but is not limited to any specific embodiment.

Although not illustrated in FIG. 2, the substrate SS may include the driving elements and signal lines for the pixels PX. The substrate SS may have a laminated structure with a plurality of conductive layers and a plurality of organic and/or inorganic layers.

The display layer DPL may be disposed on the substrate SS. The display layer DPL may be electrically connected to the driving elements and signal lines of the substrate SS. The display layer DPL may include the display elements of the pixels PX. For example, if the display panel DP is an organic light-emitting display panel, the display layer DPL may include an organic light-emitting layer. The display area DA may correspond to the area where the display layer DPL is disposed.

The encapsulation layer EN may be disposed on the display layer DPL to cover the display layer DPL and protect the display layer DPL from an outside. Although not shown in FIG. 2, the encapsulation layer EN may have a shape that also covers the sides of the display layer DPL. Depending on the type of display panel DP, the encapsulation layer EN may be omitted or replaced with another display substrate.

The flexible printed circuit board FPCB may be coupled to the non-display area NDA of the display panel DP and to the main circuit board MPCB and configured to electrically connect the main circuit board MPCB to the display panel DP. The flexible printed circuit board FPCB may be disposed on one side of the display panel DP extending along the first direction DR1. Further details regarding the flexible printed circuit board FPCB will be described later.

The main circuit board MPCB may be electrically connected to the flexible printed circuit board FPCB. The main circuit board MPCB may be configured to provide image data, control signals, power supply voltage, and the like to the display panel DP or a driving circuit (not shown). The main circuit board MPCB, which is a wiring board distinct from the flexible printed circuit board FPCB, may include both active and passive elements. The main circuit board MPCB may be flexible or rigid and is not limited to any particular embodiment.

The display device DD may further include a connecting member (not shown), which is disposed between the main circuit board MPCB and the flexible printed circuit board FPCB to electrically connect the main circuit board MPCB with the flexible printed circuit board FPCB and disposed between the display panel DP and the flexible printed circuit board FPCB to electrically connect the display panel DP with the flexible printed circuit board FPCB.

The connecting member (not shown) may have electrical conductivity and may be adhesive. The connecting member (not shown) may include a thermosetting or photocuring material. For example, the connecting member (not shown) may include an anisotropic conductive film (ACF).

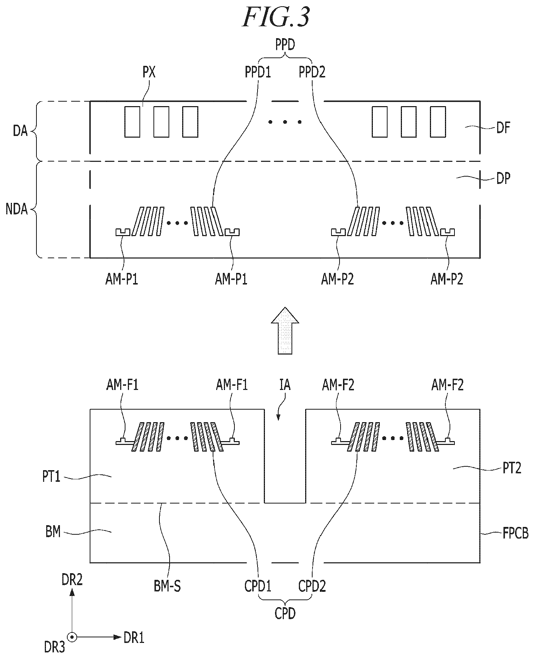

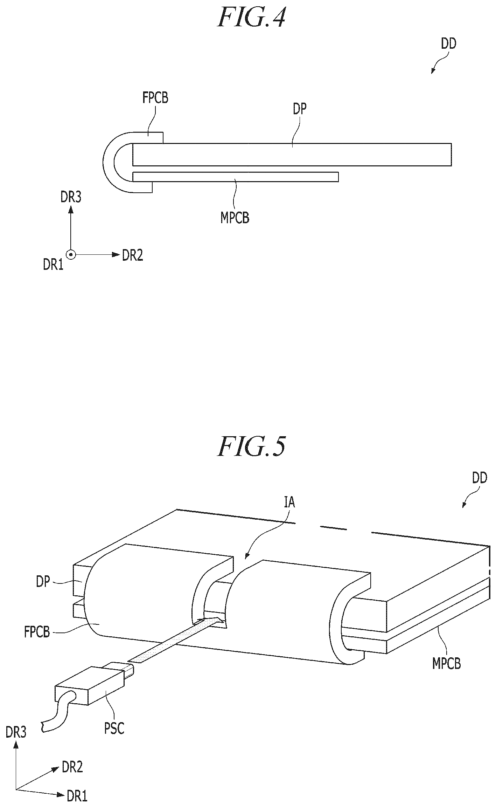

FIG. 3 is a cross-sectional view showing a separated portion of the display device. FIG. 4 is a cross-sectional view of the display device. FIG. 5 is a perspective view showing a part of the display device.

Referring to FIG. 3, the flexible printed circuit board FPCB includes a base portion BM, a first protrusion PT1, a second protrusion PT2, and connection pads CPD.

The base portion BM may provide an inner surface BM-S from which the first protrusion PT1 and the second protrusion PT2 protrude. The base portion BM, the first protrusion PT1, and the second protrusion PT2 may have an integrated shape and may have the same laminated structure.

The first protrusion PT1 protrudes in the second direction DR2 from one side extending along the first direction DR1 of the flexible printed circuit board FPCB. The first protrusion PT1 may be an area where the first connection pads CPD1 are disposed and may be coupled to the non-display area NDA of the display panel DP.

The second protrusion PT2 protrudes in the second direction DR2 from one side extending along the first direction DR1 of the flexible printed circuit board FPCB. The second protrusion PT2 may be spaced apart from the first protrusion PT1 in the first direction DR1. The second protrusion PT2 may be an area where the second connection pads CPD2 are disposed and may be coupled to the non-display area NDA of the display panel DP.

The base portion BM, the first protrusion PT1, and the second protrusion PT2 may include polyimide (PI).

Referring to FIG. 3, the connection pads CPD may be divided into first connection pads CPD1, which are disposed on the first protrusion PT1, and second connection pads CPD2, which are disposed on the second protrusion PT2. In a plan view, the connection pads CPD are obscured by the first protrusion PT1 and the second protrusion PT2; however, for the sake of description, the connection pads CPD are depicted as overlapping with the first protrusion PT1 and the second protrusion PT2.

The connection pads CPD may be electrically connected to the connection terminals (not shown) of a driving circuit (not shown) included in the flexible printed circuit board FPCB. The connection pads CPD overlap in a plan view with the panel pads PPD disposed on the display panel DP and are electrically connected to the panel pads PPD. That is, the connection pads CPD may be connected with the panel pads PPD. The shapes, sizes, number and arrangement of the connection pads CPD may be the same as the shapes, sizes, number and arrangement of the panel pads PPD.

The first connection pads CPD1 are disposed on the first protrusion PT1 and may be spaced apart from each other along the first direction DR1. The second connection pads CPD2 are disposed on the second protrusion PT2 and may be spaced apart from each other along the first direction DR1. Detailed descriptions of the first connection pads CPD1 and the second connection pads CPD2 will be provided later.

The flexible printed circuit board FPCB may further include first alignment marks AM-F1 disposed on the first protrusion PT1 and second alignment marks AM-F2 disposed on the second protrusion PT2.

The first alignment marks AM-F1 may be disposed to face each other with the first connection pads CPD1 therebetween in the first direction DR1 and may be connected, respectively, to the pads located at the outermost positions of the first connection pads CPD1. However, the planar positions of the first alignment marks AM-F1 may be modified and may not be connected to the first connection pads CPD1. The first alignment marks AM-F1 may serve as reference points for controlling the coupling position of the first protrusion PT1 so that the first protrusion PT1 of the flexible printed circuit board FPCB can be readily attached to the display panel DP. The coupling position of the first protrusion PT1 may be adjusted in the first direction DR1 through the first alignment marks AM-F1.

The second alignment marks AM-F2 may be disposed to face each other with the second connection pads CPD2 therebetween in the first direction DR1 and may be connected, respectively, to the pads located at the outermost positions of the second connection pads CPD2. However, the planar positions of the second alignment marks AM-F2 may be modified and may not be connected to the second connection pads CPD2. The second alignment marks AM-F2 may serve as reference points for controlling the coupling position of the second protrusion PT2 so that the second protrusion PT2 of the flexible printed circuit board FPCB can be readily attached to the display panel DP.

By having the first alignment marks AM-F1 and second alignment marks AM-F2 disposed, respectively, on the first protrusion PT1 and second protrusion PT2, the coupling positions of the first protrusion PT1 and second protrusion PT2 may be individually adjusted.

The flexible printed circuit board FPCB may further include first alignment pads (not shown) disposed on the first protrusion PT1 and second alignment pads (not shown) disposed on the second protrusion PT2.

The flexible printed circuit board FPCB may further include dummy pad portions (not shown) disposed on the first protrusion PT1 and second protrusion PT2.

Details regarding the adjustment of the coupling positions of the first protrusion PT1 and second protrusion PT2 will be described later.

Referring to FIG. 3, the display panel DP includes a plurality of panel pads PPD disposed in the non-display area NDA, and may include first panel alignment marks AM-P1, and second panel alignment marks AM-P2.

The panel pads PPD may be divided into first panel pads PPD1 and second panel pads PPD2. The first panel pads PPD1 may be electrically connected, respectively, to the first connection pads CPD1 disposed on the first protrusion PT1, and the second panel pads PPD2 may be electrically connected, respectively, to the second connection pads CPD2 disposed on the second protrusion PT2.

The first panel alignment marks AM-P1 may be disposed to face each other with the first panel pads PPD1 therebetween, and the second panel alignment marks AM-P2 may be disposed to face each other with the second panel pads PPD2 therebetween.

The display panel DP may further include panel alignment pads (not shown) or a dummy pad portion (not shown) disposed in the non-display area NDA. Further details regarding the configuration of the display panel DP will be described later.

Referring to FIGS. 4 and 5, the flexible printed circuit board FPCB may be bent. Additionally, a cutout portion IA may be defined in an area between the first protrusion PT1 and the second protrusion PT2 of the flexible printed circuit board FPCB.

The display device may have a cutout portion IA defined in the area between the first protrusion PT1 and the second protrusion PT2, and the flexible printed circuit board FPCB may be bent, thereby forming an opening area through which external devices such as a power supply cable PSC or a Universal Subscriber Identity Module (USIM) may be brought in and out.

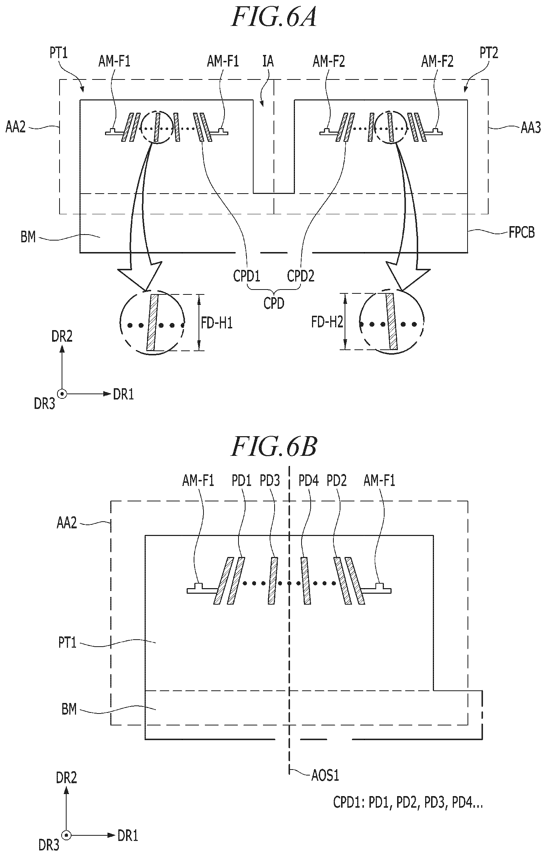

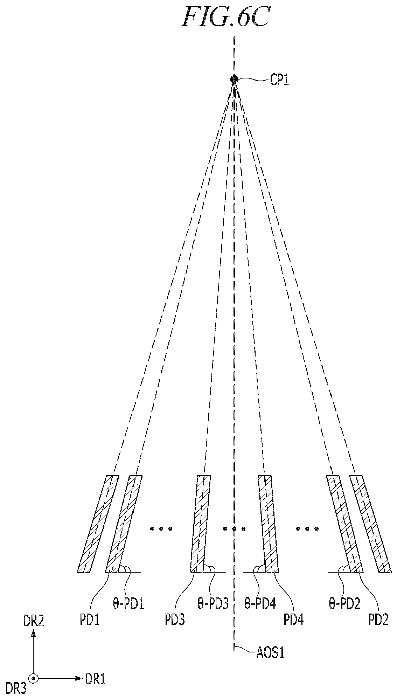

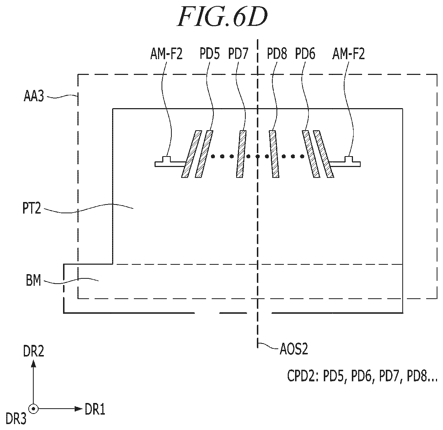

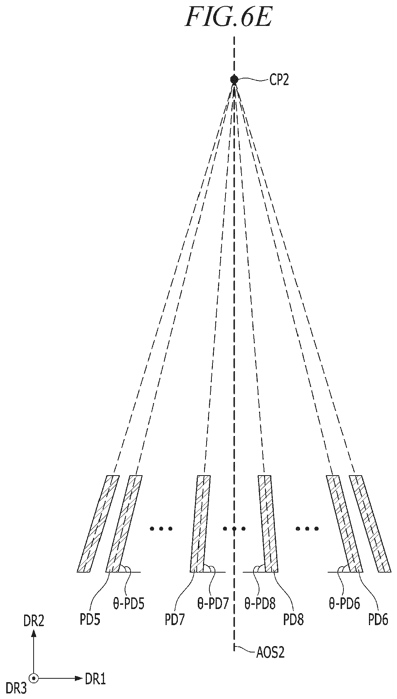

FIGS. 6A to 6E are plan views showing separated portions of the display device depicted in FIG. 1. In FIG. 6A, a portion of the flexible printed circuit board FPCB, separated from the display panel (not shown), is shown. FIG. 6B is an enlarged view of the AA2 area in FIG. 6A. FIG. 6C is a plan view showing a portion of the first connection pads CPD1. For the sake of description, a portion of the first connection pads CPD1 from FIG. 6B is shown in FIG. 6C. FIG. 6D is an enlarged view of the AA3 area in FIG. 6A. FIG. 6E is a plan view showing a portion of the second connection pads CPD2. For the sake of description, a portion of the first connection pads CPD1 from FIG. 6B is shown in FIG. 6E.

Referring to FIG. 6A, the first connection pads CPD1 may be disposed on the first protrusion PT1 and may be spaced apart from each other along the first direction DR1. Similarly, the second connection pads CPD2 may be disposed on the second protrusion PT2 and may be spaced apart from each other along the first direction DR1. The heights FD-H1 of the first connection pads CPD1 in the second direction DR2 may be identical, and the heights FD-H2 of the second connection pads CPD2 in the second direction DR2 may also be identical.

Referring to FIGS. 6B and 6C, at least some of the first connection pads CPD1 extend in a direction inclined with respect to the first and second directions.

At least two of the first connection pads CPD1 may extend in different directions from each other. An acute, first angle θ-PD1 formed between the first direction DR1 and the direction in which a first pad PD1 of the first connection pads CPD1 extends may differ from an acute, third angle θ-PD3 formed between the first direction DR1 and the direction in which a third pad PD3 of the first connection pads CPD1 extends. Similarly, an acute, second angle θ-PD2 formed between the first direction DR1 and the direction in which the second pad PD2 of the first connection pads CPD1 extends may differ from an acute, fourth angle θ-PD4 formed between the first direction DR1 and the direction in which the fourth pad PD4 of the first connection pads CPD1 extends.

The first pad PD1 and the second pad PD2 of the first connection pads CPD1 may be symmetric about a first axis of symmetry AOS1. That is, the first angle θ-PD1 and the second angle θ-PD2 may be the same and may be symmetric about the first axis of symmetry AOS1. The first axis of symmetry AOS1 may be a symmetry axis extending in the second direction DR2 from a midpoint between the outermost first connection pads CPD1. Moreover, the third pad PD3 and the fourth pad PD4 of the first connection pads CPD1 may be symmetric about the first axis of symmetry AOS1.

The imaginary lines extending along longitudinal directions of the first connection pads CPD1 may converge at a single, first convergence point CP1. These imaginary lines may extend in parallel to the directions in which the first connection pads CPD1 extend from their centers, respectively. As the imaginary lines converge at the first convergence point CP1, the acute angles formed by the first connection pads CPD1 with the first direction DR1 may vary, with the angles becoming progressively larger toward the midpoint between the outermost first connection pads CPD1.

Referring to FIGS. 6D and 6E, at least some of the second connection pads CPD2 extend in a direction inclined with respect to the first and second directions. At least two of the second connection pads CPD2 may extend in different directions from each other. An acute, fifth angle θ-PD5 formed between the first direction DR1 and the direction in which a fifth pad PD5 of the second connection pads CPD2 extends may differ from an acute, seventh angle θ-PD7 formed between the first direction DR1 and the direction in which a seventh pad PD7 of the second connection pads CPD2 extends. Similarly, an acute, sixth angle θ-PD6 formed between the first direction DR1 and the direction in which a sixth pad PD6 of the second connection pads CPD2 extends may differ from an acute, eighth angle θ-PD8 formed between the first direction DR1 and the direction in which and eighth pad PD8 of the second connection pads CPD2 extends.

The fifth pad PD5 and the seventh pad PD7 of the second connection pads CPD2 may be symmetric about a second axis of symmetry AOS2. That is, the fifth angle θ-PD5 and the seventh angle θ-PD7 may be the same and may be symmetric about the second axis of symmetry AOS2. The second axis of symmetry AOS2 may be a symmetry axis extending in the second direction DR2 from a midpoint between the outermost second connection pads CPD2. Moreover, the seventh pad PD7 and the eighth pad PD8 of the second connection pads CPD2 may also be symmetric about the second axis of symmetry AOS2.

The imaginary lines extending along longitudinal directions of the second connection pads CPD2 may converge at a single, second convergence point CP2. These imaginary lines may extend in parallel to the directions in which the second connection pads CPD2 extends from their centers, respectively.

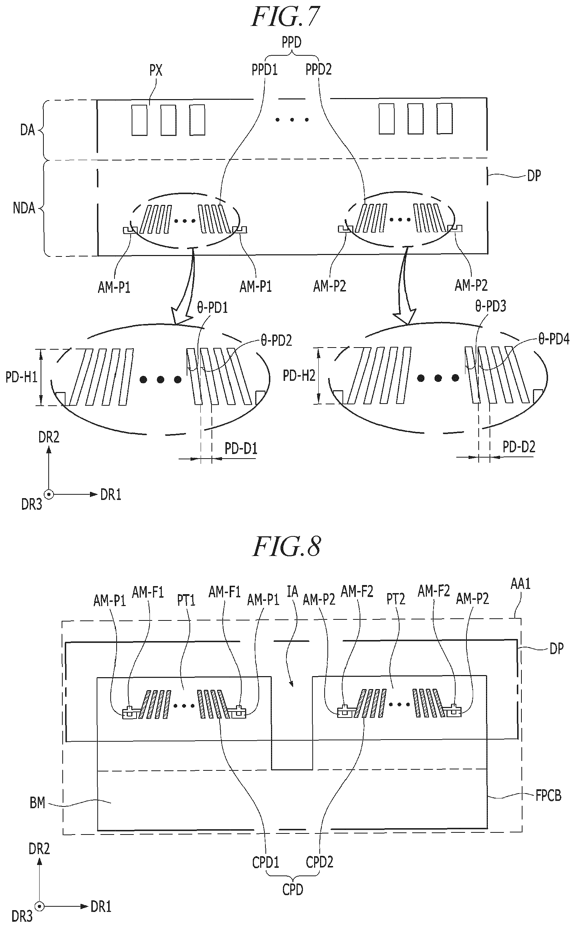

FIG. 7 is a plan view showing a portion of the display panel. FIG. 7 illustrates a portion of the display panel DP, separated from the display device.

Referring to FIG. 7, the display panel DP may include a plurality of panel pads PPD disposed in the non-display area NDA. The plurality of panel pads PPD may be divided into first panel pads PPD1 and second panel pads PPD2.

The first panel pads PPD1 may be disposed in the non-display area NDA of the display panel DP and may be arranged spaced apart from each other along the first direction DR1.

The first panel pads PPD1 may be disposed corresponding, respectively, to the first connection pads CPD1 (see FIG. 6A). That is, each of the first panel pads PPD1 may overlap and electrically connect with each of the first connection pads CPD1 (see FIG. 6A) in a plan view. The first panel pads PPD1 may be connected, respectively, to the first connection pads CPD1 (see FIG. 6A).

The first panel pads PPD1 may each have a shape similar to the corresponding first connection pads CPD1 (see FIG. 6A) with which they overlap in a plan view.

The second panel pads PPD2 may be disposed spaced apart from the first panel pads PPD1 along the first direction DR1. The second panel pads PPD2 may be disposed in the non-display area NDA of the display panel DP and may be arranged spaced apart from each other along the first direction DR1.

The second panel pads PPD2 may be disposed corresponding, respectively, to the second connection pads CPD2 (see FIG. 6A). That is, each of the second panel pads PPD2 may overlap and electrically connect with each of the second connection pads CPD2 (see FIG. 6A) in a plan view. The second panel pads PPD2 may be connected, respectively, to the second connection pads CPD2 (see FIG. 6A).

The second panel pads PPD2 may each have a shape similar to the corresponding second connection pads CPD2 (see FIG. 6A) with which they overlap in a plan view.

The display panel DP may further include first panel alignment marks AM-P1 disposed facing each other with the first panel pads PPD1 therebetween and second panel alignment marks AM-P2 disposed facing each other with the second panel pads PPD2 therebetween. The first panel alignment marks AM-P1 may be disposed corresponding, respectively, to the first alignment marks AM-F1 included in the flexible printed circuit board FPCB (see FIG. 6B). The second panel alignment marks AM-P2 may be disposed corresponding, respectively, to the second alignment marks AM-F2 included in the flexible printed circuit board FPCB (see FIG. 6B). The first panel alignment marks AM-P1 and the second panel alignment marks AM-P2 may serve as reference points for adjusting the coupling position of the flexible printed circuit board FPCB (see FIG. 6B) to ensure that the flexible printed circuit board FPCB (see FIG. 6B) is readily attached to the display panel DP. The adjustment of the coupling position of the flexible printed circuit board FPCB will be described later in greater detail.

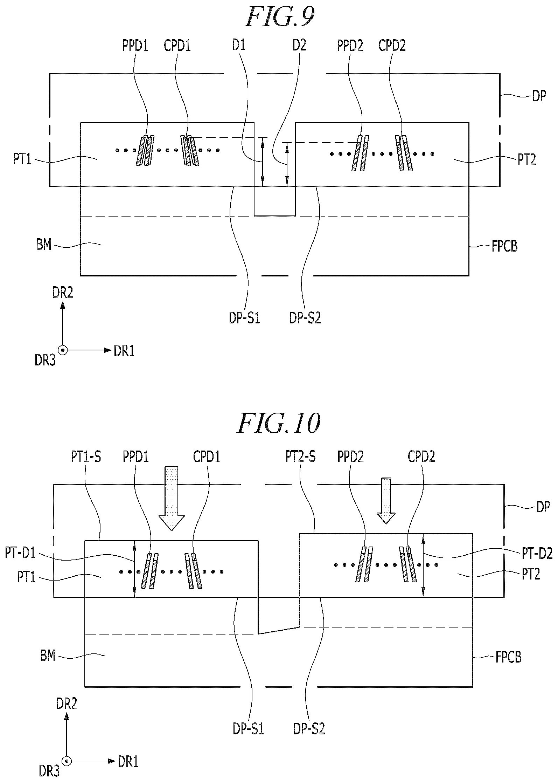

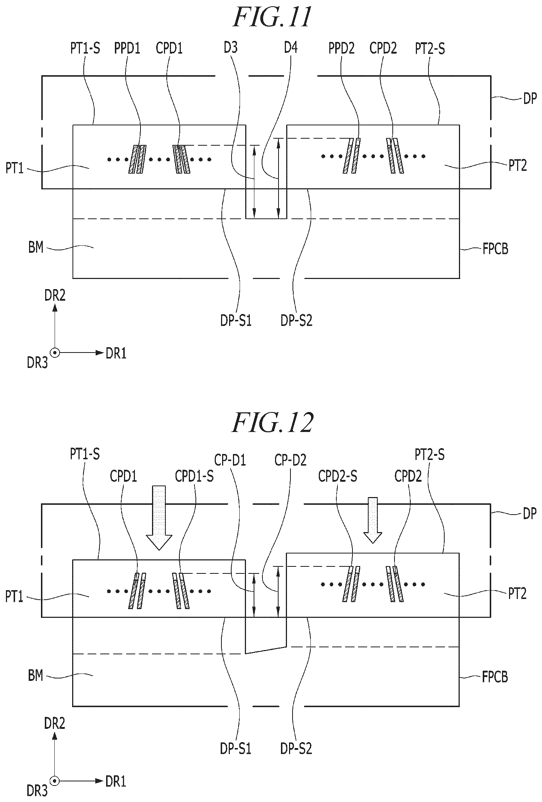

FIG. 8 is an enlarged view of the AA1 area in FIG. 1. FIG. 9 is a diagram showing a part of the display device. FIG. 10 is a diagram showing a part of the display device. FIG. 11 is a diagram showing a part of the display device. FIG. 12 is a diagram showing a part of the display device.

Hereinafter, the display device will be described with reference to FIGS. 8 to 12. The same reference numerals/symbols are used for the same components described in FIGS. 1 to 7, and redundant descriptions are omitted.

Referring to FIG. 8, the flexible printed circuit board FPCB may be coupled to the display panel DP. Each of the first connection pads CPD1 disposed on the first protrusion PT1 of the flexible printed circuit board FPCB and each of the first panel pads PPD1 of the display panel DP may overlap with each other in a plan view and may be electrically connected to each other. Likewise, each of the second connection pads CPD2 disposed on the second protrusion PT2 of the flexible printed circuit board FPCB and each of the second panel pads PPD2 of the display panel DP may overlap with each other in a plan view and may be electrically connected to each other.

The flexible printed circuit board FPCB may further include alignment pads (not shown) disposed on the first protrusion PT1 and the second protrusion PT2. The alignment pads (not shown) may be used to determine whether the first protrusion PT1 and the second protrusion PT2 are aligned.

The first alignment marks AM-F1 and the first panel alignment marks AM-P1 may be used to determine whether the first protrusion PT1 is aligned. For example, the position of the first protrusion PT1 may be aligned so that the protruding portions of the first alignment marks AM-F1 in the second direction DR2 and the recessed portions of the shaded first panel alignment marks AM-P1 are aligned along the second direction DR2. However, this is presented by way of example, and the display device may be aligned using various alignment techniques and may include various alignment marks.

Each of the first connection pads CPD1 and the first panel pads PPD1 may overlap with each other to be stably connected. The first connection pads CPD1 and the first panel pads PPD1 may be electrically connected, allowing image data, control signals, and power supply voltage provided by the main circuit board MPCB (see FIG. 1) to be transferred to the display panel DP. That is, the first connection pads CPD1 and the first panel pads PPD1 may be input/output pads for transferring electrical signals, while the alignment marks, alignment pads, and dummy pad portions may have functions different from those of the input/output pads.

Although the first connection pads CPD1 and the first panel pads PPD1 are illustrated as corresponding on a one-to-one basis, the present disclosure is not limited to what is illustrated herein. In the display device, the first connection pads CPD1 and the first panel pads PPD1 may be provided in different quantities, and the display device is not limited to any particular embodiment.

The first connection pads CPD1 and the first alignment marks AM-F1 may be disposed on the first protrusion PT1 of the flexible printed circuit board FPCB, and the position of the first protrusion PT1 may be adjusted so that each of the first connection pads CPD1 overlaps and stably connects with each of the first panel pads PPD1 of the display panel DP. Likewise, the second connection pads CPD2 and the second alignment marks AM-F2 may be disposed on the second protrusion PT2 of the flexible printed circuit board FPCB, and the coupling position of the second protrusion PT2 may be adjusted so that each of the second connection pads CPD2 overlaps and stably connects with each of the second panel pads PPD2 of the display panel DP. That is, the coupling positions of the first protrusion PT1 and the second protrusion PT2 may be individually controlled.

Each of the second connection pads CPD2 and each of the second panel pads PPD2 may overlap and be stably connected with each other. The second connection pads CPD2 and the second panel pads PPD2 are electrically connected, allowing image data, control signals, and power supply voltage provided by the main circuit board MPCB (FIG. 1) to be transferred to the display panel DP. That is, the second connection pads CPD2 and the second panel pads PPD2 may be input/output pads for transferring electrical signals, while the alignment marks, alignment pads, and dummy pad portions may have functions different from those of the input/output pads.

The flexible printed circuit board FPCB may include the first alignment marks AM-F1 and the first connection pads CPD1 disposed on the first protrusion PT1 and include the second alignment marks AM-F2 and the second connection pads CPD2 disposed on the second protrusion PT2. The coupling positions of the first protrusion PT1 and the second protrusion PT2 may be individually controlled, allowing the elongation rates of the first protrusion PT1 and the second protrusion PT2 to be individually controlled. Therefore, it may be possible to individually fine tune the joining positions of the first connection pads CPD1 and the first panel pads PPD1 and the joining positions of the second connection pads CPD2 and the second panel pads PPD2. The display device DD having these characteristics may have improved bonding precision and thus enhanced reliability of electrical connection.

FIGS. 9 to 12 are diagrams showing the process of adjusting the coupling position of the flexible printed circuit board. In FIGS. 9 to 12, some components are omitted for convenience of description.

FIG. 9 shows a portion of the display device before the coupling positions of the first protrusion PT1 and the second protrusion PT2 are adjusted, and FIG. 10 shows the portion of the display device after the coupling positions of the first protrusion PT1 and the second protrusion PT2 are adjusted.

Referring to FIG. 9, a distance D1 from one side of the first connection pads CPD1 in the second direction DR2 to one side DP-S1 of the display panel DP overlapping with the first protrusion PT1 in the second direction DR2 may differ from a distance D2 from one side of the second connection pads CPD2 in the second direction DR2 to one side DP-S2 of the display panel DP overlapping with the second protrusion PT2 in the second direction DR2. In such a case, the degree to which the first protrusion PT1 is adjusted in the second direction DR2 to ensure that each of the first connection pads CPD1 is stably connected to each of the first panel pads PPD1 may differ from the degree to which the second protrusion PT2 is adjusted in the second direction DR2 to ensure that each of the second connection pads CPD2 is stably connected to each of the second panel pads PPD2.

Referring to FIG. 10, the coupling positions of the first protrusion PT1 and the second protrusion PT2 may each be individually adjusted so that each of the first connection pads CPD1 overlaps with and is stably connected to each of the first panel pads PPD1, and each of the second connection pads CPD2 overlaps with and is stably connected to each of the second panel pad PPD2 in a plan view. Here, a first distance PT-D1 from one side PT1-S of the first protrusion PT1 extending in the first direction DR1 to one side DP-S1 of the display panel DP overlapping with the first protrusion PT1 in the second direction DR2 may differ from a second distance PT-D2 from one side PT2-S of the second protrusion PT2 extending in the first direction DR1 to one side DP-S2 of the display panel DP overlapping with the second protrusion PT2 in the second direction DR2.

FIG. 11 shows a portion of the display device before the coupling positions of the first protrusion PT1 and the second protrusion PT2 are adjusted, and FIG. 12 shows the portion of the display device after the coupling positions of the first protrusion PT1 and the second protrusion PT2 are adjusted.

Referring to FIG. 11, a distance D3 from one side PPD1-S of the first panel pads PPD1 in the second direction DR2 to one side DP-S1 of the display panel DP overlapping with the first protrusion PT1 in the second direction DR2 may differ from a distance D4 from one side PPD2-S of the second panel pads PPD2 in the second direction DR2 to one side DP-S2 of the display panel DP overlapping with the second protrusion PT2 in the second direction DR2. In such a case, the degree to which the first protrusion PT1 is adjusted in the second direction DR2 to ensure that each of the first connection pads CPD1 is stably connected to each of the first panel pads PPD1 may differ from the degree to which the second protrusion PT2 is adjusted in the second direction DR2 to ensure that each of the second connection pads CPD2 is stably connected to each of the second panel pads PPD2.

Referring to FIG. 12, the positions of the first protrusion PT1 and the second protrusion PT2 may be individually adjusted so that each of the first connection pads CPD1 overlaps with and is stably connected to each of the first panel pads PPD1, and each of the second connection pads CPD2 overlaps with and is stably connected to each of the second panel pads PPD2. Here, a third distance CP-D1 from one side CPD1-S of the first connection pads CPD1 (i.e., the side close to the one side PT1-S of the first protrusion PT1 extending in the first direction DR1) to one side DP-S1 of the display panel DP overlapping with the first protrusion PT1 in the second direction DR2 may differ from a fourth distance CP-D2 from one side CPD2-S of the second connection pads CPD2 (i.e., the side close to the one side PT2-S of the second protrusion PT2 extending in the first direction DR1) to one side DP-S2 of the display panel DP overlapping with the second protrusion PT2 in the second direction DR2.

The adjustment of the coupling position of the flexible printed circuit board FPCB with the display panel DP, as described with reference to FIGS. 9 to 12, may be performed by individually controlling the positions of the first protrusion PT1 and the second protrusion PT2. Accordingly, each of the first connection pads CPD1 may be stably connected to each of the first panel pads PPD1, and each of the second connection pads CPD2 may be stably connected to each of the second panel pads PPD2. Here, if the positions of the first protrusion PT1 and the second protrusion PT2 are individually controlled, the first distance PT-D1 and the second distance PT-D2 may differ from each other, and the third distance CP-D1 and the fourth distance CP-D2 may differ from each other.

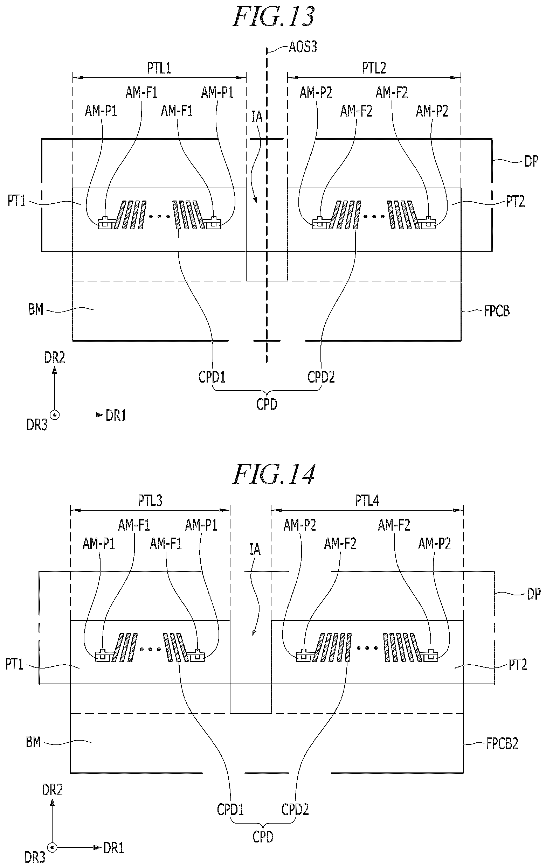

FIG. 13 is a plan view showing a part of the display device. Referring to FIG. 13, the flexible printed circuit board FPCB may include the first protrusion PT1 and the second protrusion PT2. A width PTL1 of the first protrusion PT1 in the first direction DR1 may be the same as a width PTL2 of the second protrusion PT2 in the first direction DR1. Moreover, the number of the first connection pads CPD1 disposed on the first protrusion PT1 may be the same as the number of the second connection pads CPD2 disposed on the second protrusion PT2. In other words, the first protrusion PT1 and the second protrusion PT2 may be symmetrical about a symmetry axis AOS3 extending in the second direction DR2. Having a symmetrical structure for the first protrusion PT1 and the second protrusion PT2 may provide advantages when the elongation rate of the protrusions changes during the manufacturing process.

FIG. 14 is a plan view showing a part of the display device. Referring to FIG. 14, a flexible printed circuit board FPCB2 may include the first protrusion PT1 and the second protrusion PT2. A width PTL3 of the first protrusion PT1 in the first direction DR1 may differ from a width PTL4 of the second protrusion PT2 in the first direction DR1. Additionally, the numbers of the first connection pads CPD1 disposed on the first protrusion PT1 and the numbers of the second connection pads CPD2 disposed on the second protrusion PT2 may differ from each other. That is, the width PTL3 of the first protrusion PT1 and the width PTL4 of the second protrusion PT2 may be adjusted to correspond to the modified design of the display device DD, and the numbers of the first connection pads CPD1 and the second connection pads CPD2 may also be adjusted.

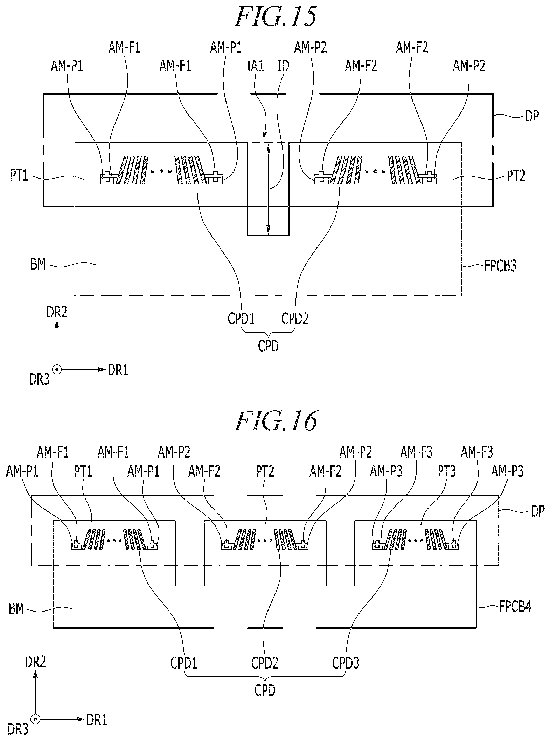

FIG. 15 is a plan view showing a part of the display device. Referring to FIG. 15, a flexible printed circuit board FPCB3 may include the first protrusion PT1 and the second protrusion PT2. Here, a cutout portion IA1 may be defined in an area between the first protrusion PT1 and the second protrusion PT2. A depth ID of the cutout portion IA1 in the second direction DR2 may be 5 mm or more.

In a comparative example, when the depth of the cutout portion is less than 5 mm, slippage between the alignment head and the protrusion may occur while aligning the flexible printed circuit board on the display panel in the manufacturing process of the display device. However, in the display device DD according to an embodiment, the depth of the cutout portion may be 5 mm or more, and during the process of adjusting the position of the protrusion using the alignment head, the position of one side in the first direction DR1 may be adjusted by up to 3 micrometers (µm). Specifically, as the depth of the cutout portion increases beyond a minimum of 5 mm, the range in which the position of the protrusion can be adjusted on one side in the first direction DR1 may increase by at least 3 µm. For example, if the depth of the cutout portion is 10 mm, the adjustable range of the protrusion position may extend to 15 µm on one side of the first direction DR1 and 50 µm on the other side. However, the present disclosure is not limited to what is described herein, and the depth of the cutout portion may be adjusted to an appropriate value depending on the design of the product.

FIG. 16 is a plan view showing a part of the display device. Referring to FIG. 16, a flexible printed circuit board FPCB4 may further include a third protrusion PT3, which is spaced apart from the first protrusion PT1 and the second protrusion PT2 in the first direction DR1, and third connection pads CPD3 disposed on the third protrusion PT3. Moreover, the flexible printed circuit board FPCB4 may further include third alignment marks AM-F3 disposed on the third protrusion PT3, facing each other with the third connection pads CPD3 therebetween.

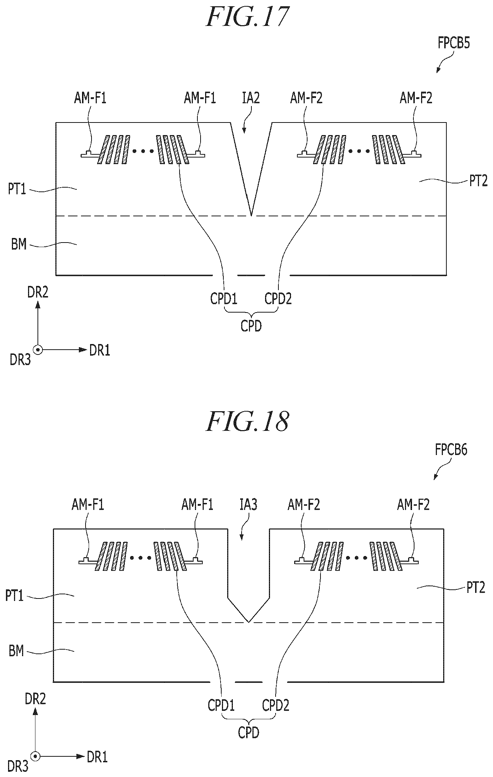

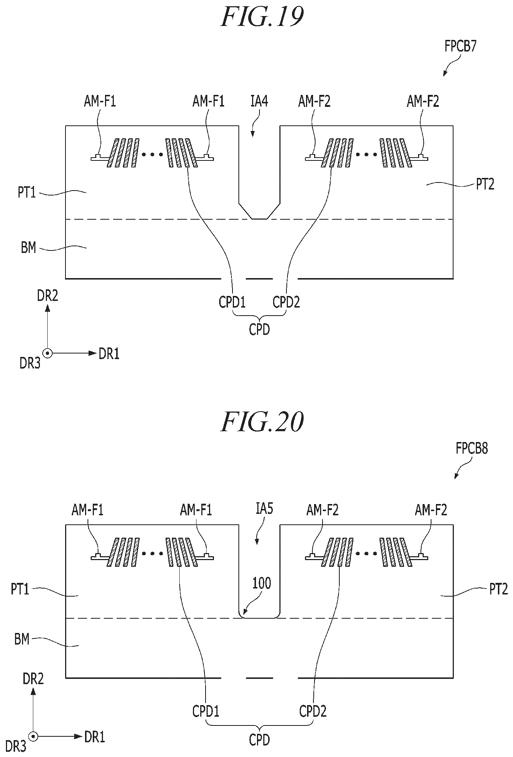

FIG. 17 is a plan view showing a part of the display device. FIG. 18 is a plan view showing a part of the display device. FIG. 19 is a plan view showing a part of the display device. Referring to FIG. 17, a cutout portion IA2 defined in a flexible printed circuit board FPCB5 may have a triangular shape. Referring to FIG. 18, a cutout portion IA3 defined in a flexible printed circuit board FPCB6 may have a pentagonal shape. Referring to FIG. 19, a cutout portion IA4 defined in a flexible printed circuit board FPCB7 may have a hexagonal shape. Although the examples described with reference to FIGS. 17 to 19 illustrate cutout portions with triangular, pentagonal, and hexagonal shapes, respectively, they are not limited to these examples, and the shape of the cutout portion may vary in various ways.

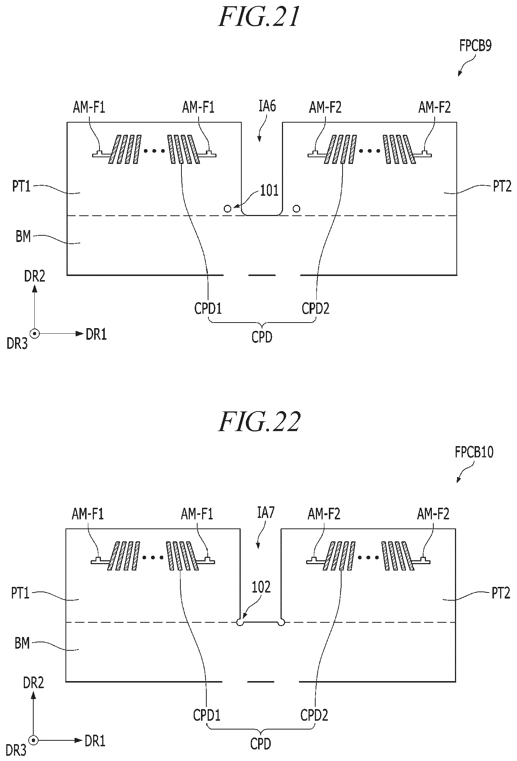

FIG. 20 is a plan view showing a part of the display device. FIG. 21 is a plan view showing a part of the display device. FIG. 22 is a plan view showing a part of the display device.

Referring to FIG. 20, a cutout portion IA5 defined in a flexible printed circuit board FPCB8 may have fillet-shaped corners 100. The fillet-shaped corners 100 may provide an effect of dispersing stress applied to the corners of the cutout portion IA5 during the alignment process or thermal expansion of the first protrusion PT1 and the second protrusion PT2 in the manufacturing process of the electronic device. This may prevent damage to the flexible printed circuit board FPCB8 and improve the stability and reliability of the electronic device during the manufacturing process.

Referring to FIG. 21, a flexible printed circuit board FPCB9 may further include a hole 101 formed adjacent to cutout portion IA6. The hole 101 may provide an effect of dispersing stress applied to the corners of the cutout portion IA6 due to thermal expansion or alignment stress in the manufacturing process. This may prevent damage to the flexible printed circuit board FPCB9 and improve the stability and reliability of the electronic device during the manufacturing process.

Referring to FIG. 22, a cutout portion IA7 defined in a flexible printed circuit board FPCB10 may have rounded corners 102. The rounded corners 102 may reduce stress applied to the corners of the cutout portion IA7 due to the alignment process or thermal expansion of the first protrusion PT1 and the second protrusion PT2 during the manufacturing process of the electronic device. This may prevent damage to the flexible printed circuit board FPCB10 and improve the stability and reliability of the electronic device during the manufacturing process.

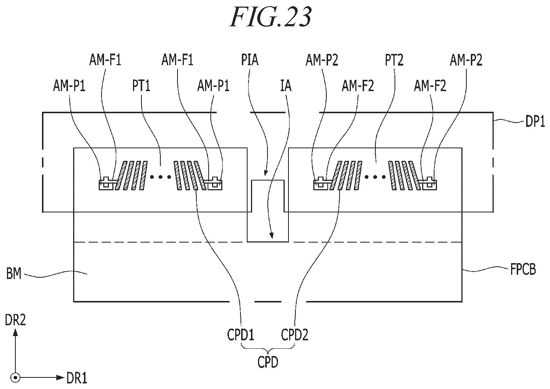

FIG. 23 is a plan view showing a part of the display device. Referring to FIG. 23, a panel cutout portion PIA may be defined between the first protrusion PT1 and the second protrusion PT2 of the flexible printed circuit board FPCB. The panel cutout portion PIA may be formed on one side of the display panel DP1 in the second direction DR2. The panel cutout portion PIA may serve as an opening area (not shown) through which connection terminals of external devices can be brought in and out. However, the function of the panel cutout portion PIA is not limited to what is described herein.

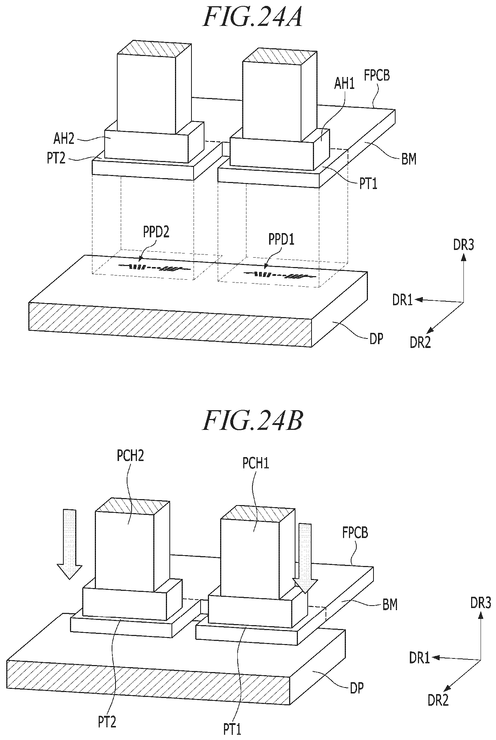

FIGS. 24A to 24C are perspective views sequentially illustrating the method for manufacturing a display device. The method for manufacturing the display device DD may include: preparing a display panel DP that includes panel pads PPD arranged along a first direction DR1; preparing a flexible printed circuit board FPCB that includes a base portion BM, a first protrusion PT1, a second protrusion PT2 spaced apart from the first protrusion PT1 in the first direction DR1, first connection pads CPD1 disposed on the first protrusion PT1, and second connection pads CPD2 disposed on the second protrusion PT2; aligning the flexible printed circuit board FPCB on the display panel DP; preliminarily pressing the display panel and the flexible printed circuit board; and finally pressing the display panel and the flexible printed circuit board.

Referring to FIG. 24A, the step of aligning the flexible printed circuit board FPCB on the display panel DP may involve vacuum-adsorbing the first protrusion PT1 using a first alignment head AH1 and vacuum-adsorbing the second protrusion PT2 using a second alignment head AH2 to individually adjust positions of the first protrusion PT1 and the second protrusion PT2. The positions of the first protrusion PT1 and the second protrusion PT2 may be adjusted by the first alignment head AH1 and the second alignment head AH2, respectively, so that the first connection pads CPD1 (not shown) are aligned to overlap with first panel pads PPD1, and the second connection pads CPD2 (not shown) are aligned to overlap with second panel pads PPD2.

Referring to FIG. 24B, the step of preliminarily pressing the display panel DP and the flexible printed circuit board FPCB may involve preliminarily pressing the first protrusion PT1 and the display panel DP on the first protrusion PT1 using a first preliminary compression head PCH1, and preliminarily pressing the second protrusion PT2 and the display panel DP on the second protrusion PT2 using a second preliminary compression head PCH2. The first preliminary compression head PCH1 and the second preliminary compression head PCH2 may operate simultaneously to preliminarily press the first protrusion PT1, the second protrusion PT2, and the display panel DP simultaneously. However, the present disclosure is not limited to what is described herein.

In a comparative example, the step of preliminarily pressing the display panel and the flexible printed circuit board involves preliminarily pressing both the first protrusion and the second protrusion onto the display panel simultaneously using a single preliminary compression head. In such a case, due to the height difference between the first and second protrusions, the flexible printed circuit board and the display panel may be unevenly pressed.

However, according to the method for manufacturing a display device according to an embodiment, the first protrusion PT1 and the second protrusion PT2 are preliminarily pressed to the display panel DP individually by the first preliminary compression head PCH1 and the second preliminary compression head PCH2, respectively. Accordingly, pressure is evenly applied to the first protrusion PT1 and the second protrusion PT2. As a result, it becomes possible to preliminarily press the flexible printed circuit board FPCB and the display panel DP in a stable fashion, regardless of the height difference between the first protrusion PT1 and the second protrusion PT2.

The first alignment head AH1 and the first preliminary compression head PCH1 may be configured as an integrated device, and the second alignment head AH2 and the second preliminary compression head PCH2 may also be configured as an integrated device. That is, the first alignment head AH1 and the second alignment head AH2 may each have a vacuum adsorption function and simultaneously act as a preliminary compression head. Therefore, the steps of aligning and preliminarily pressing the first protrusion PT1 and the second protrusion PT2 on the display panel DP may be performed as a series of processes. However, the embodiment is not limited to what is described herein, and the first alignment head AH1 and the first preliminary compression head PCH1 may be separate components, and the second alignment head AH2 and the second preliminary compression head PCH2 may also be separate components.

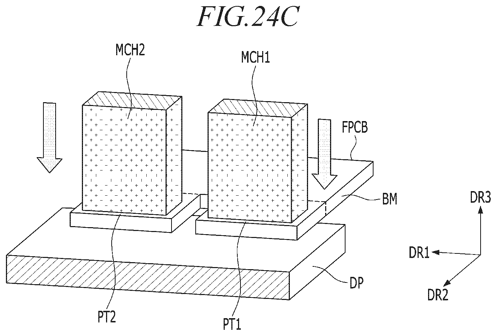

Referring to FIG. 24C, the step of finally pressing the display panel DP and the flexible printed circuit board FPCB may involve finally pressing the first protrusion PT1 and the display panel DP on the first protrusion PT1 using a first final compression head MCH1, and finally pressing the second protrusion PT2 and the display panel DP on the second protrusion PT2 using a second final compression head MCH2.

With the method for manufacturing a display device, the first protrusion PT1 and the second protrusion PT2 are finally pressed individually onto the display panel DP by the first final compression head MCH1 and the second final compression head MCH2, respectively, to evenly transfer heat and pressure to each of the first protrusion PT1 and the second protrusion PT2. Therefore, it becomes possible that the flexible printed circuit board FPCB and the display panel DP are finally pressed in a stable fashion.

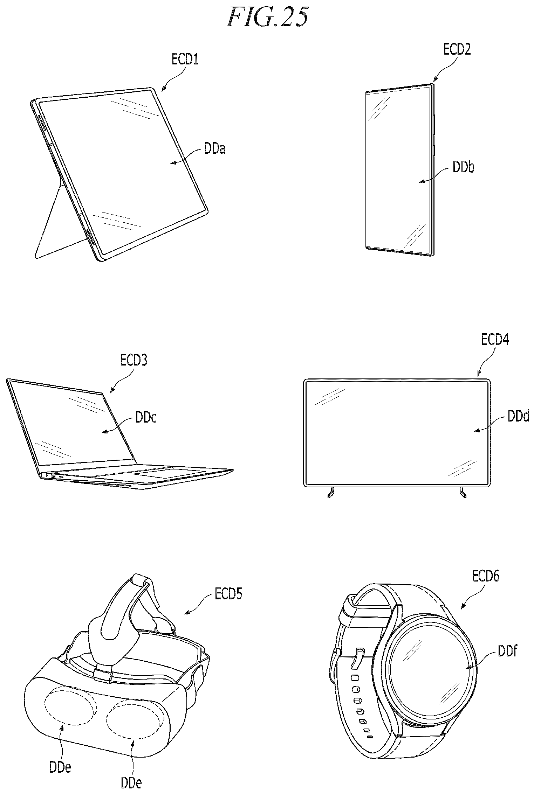

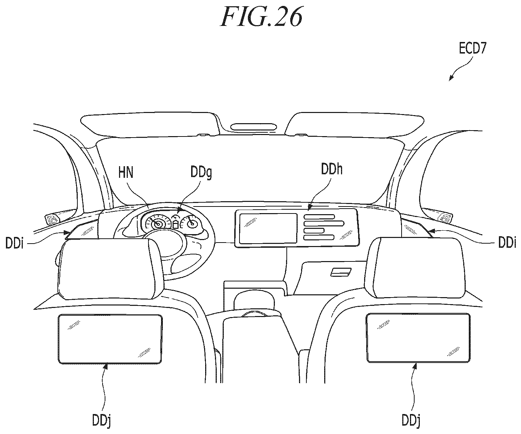

FIGS. 25 and 26 are diagrams showing electronic devices to which the display device according to embodiments may be applied. Referring to FIG. 25, a first electronic device ECD1 is illustrated as a tablet PC that includes a first display device DDa. A second electronic device ECD2 is illustrated as a portable terminal that includes a second display device DDb. A third electronic device ECD3 is illustrated as a laptop that includes a third display device DDc. A fourth electronic device ECD4 is illustrated as a television that includes a fourth display device DDd. A fifth electronic device ECD5 is illustrated as a head-mounted display device that includes a fifth display device DDe. A sixth electronic device ECD6 is illustrated as a digital watch that includes a sixth display device DDf.

Referring to FIG. 26, a seventh electronic device ECD7 is illustrated as a vehicle that includes seventh through tenth display devices DDg-DDj. Although the seventh electronic device ECD7 is shown as an automobile, the present disclosure is not limited to what is shown herein and may encompass various means of transportation, such as bicycles, motorcycles, trains, ships, or airplanes.

The seventh display device DDg is positioned in front of a steering wheel HN in the driver's line of sight and may be used to display information such as the vehicle's speed on the instrument panel. The eighth display device DDh may be positioned on the dashboard, separate from the seventh display device DDg, and may be used to display information related to the vehicle's control interface, audio, temperature, road conditions, or video content. The ninth display device DDi may be positioned on sides of the driver's seat and the passenger seat and may function as a digital side mirror. The ninth display device DDi can display images captured from outside the vehicle. The tenth display device DDj may be positioned on the rear of the driver's and passenger's seats and may display video or other content viewable by rear-seat passengers.

At least one of the first through tenth display devices Dda-DDj may include the flexible printed circuit board FPCB described with reference to FIGS. 1 to 23.

In addition to the electronic devices illustrated in FIGS. 25 and 26, the flexible printed circuit board FPCB according to one embodiment may be applied to electronic devices in every field. For example, it is possible to apply the flexible printed circuit board FPCB according to one embodiment to devices such as printers, telephones, wearable devices, digital cameras, camcorders, viewfinders, 3D displays, tiled video walls, theaters, signs, medical devices, memories, memory processors, and storage devices.

While certain embodiments have been described above, anyone ordinarily skilled in the art to which the present disclosure pertains shall appreciate that there may be a variety of modifications and permutations of the present disclosure without departing from the scope of the invention as defined in the appended claims.

## Claims

1. A display device comprising:
a display panel comprising a substrate and a plurality of panel pads, wherein the substrate has a display area and a non-display area and the plurality of panel pads are disposed in the non-display area and arranged along a first direction; and
a flexible printed circuit board comprising a base portion, a first protrusion, a second protrusion, first connection pads, and second connection pads, wherein the first protrusion protrudes in a second direction intersecting the first direction from one side of the base portion extending in the first direction, the second protrusion protrudes in the second direction from the one side of the base portion and spaced apart from the first protrusion in the first direction, the first connection pads are disposed on the first protrusion, and the second connection pads are disposed on the second protrusion,
wherein, in a plan view, the first connection pads overlap with and are electrically connected to first panel pads of the plurality of panel pads, respectively,
wherein, in the plan view, the second connection pads overlap with and are electrically connected to second panel pads of the plurality of panel pads, respectively,
wherein at least some of the first connection pads extend in a direction inclined with respect to the first direction and the second direction, and
wherein at least some of the second connection pads extend in a direction inclined with respect to the first direction and the second direction.

2. The display device of claim 1, wherein the flexible printed circuit board further comprises at least two first alignment marks disposed on the first protrusion and at least two second alignment marks disposed on the second protrusion.

3. The display device of claim 2, wherein the at least two first alignment marks are disposed to face each other with the first connection pads therebetween in the first direction, and
wherein the at least two second alignment marks are disposed to face each other with the second connection pads therebetween in the first direction.

4. The display device of claim 1, 2 or 3, wherein at least two of the first connection pads extend in different directions from each other, and
wherein at least two of the second connection pads extend in different directions from each other.

5. The display device of any one of the preceding claims, wherein at least two of the first connection pads are symmetrical about a first axis of symmetry extending in the second direction, and
wherein at least two of the second connection pads are symmetrical about a second axis of symmetry extending in the second direction.

6. The display device of claim 1, wherein a first pad and a second pad among the first connection pads are symmetrical about a first axis of symmetry,
wherein a third pad and a fourth pad among the first connection pads are symmetrical about the first axis of symmetry,
wherein imaginary lines extending along longitudinal directions of the first connection pads converge at a first convergence point,
wherein a fifth pad and a sixth pad among the second connection pads are symmetrical about a second axis of symmetry,
wherein a seventh pad and an eighth pad among the second connection pads are symmetrical about the second axis of symmetry, and
wherein imaginary lines extending along longitudinal directions of the second connection pads converge at a second convergence point.

7. The display device of any one of the preceding claims, wherein the width of the first protrusion in the first direction is different from the width of the second protrusion in the first direction, optionally wherein the total number of first connection pads is different from the total number of second connection pads.

8. The display device of any one of the preceding claims, wherein a cutout portion is defined between the first protrusion and the second protrusion, and
wherein the depth of the cutout portion is 5 millimeters (mm) or greater in the second direction.

9. The display device of any one of claims 1 to 6, wherein the first protrusion and the second protrusion have the same length in the first direction, optionally wherein the total number of first connection pads is the same as the total number of second connection pads.

10. The display device of any one of the preceding claims, wherein the distance from one side of the first protrusion extending in the first direction to one side of the display panel overlapping with the first protrusion in the second direction is different from the distance from one side of the second protrusion extending in the first direction to one side of the display panel overlapping with the second protrusion in the second direction.

11. The display device of any one of the preceding claims, wherein the distance from ends of the first connection pads close to a side of the first protrusion extending in the first direction to one side of the display panel overlapping with the first protrusion in the second direction is different from the distance from ends of the second connection pads close to a side of the second protrusion extending in the first direction to one side of the display panel overlapping with the second protrusion in the second direction.

12. The display device of any one of the preceding claims, wherein the flexible printed circuit board further comprises a third protrusion and third connection pads,
wherein the third protrusion is spaced apart from the second protrusion in the first direction, and the third connection pads are disposed on the third protrusion,
wherein, in the plan view, the third connection pads overlap with and are electrically connected to third panel pads of the panel pads, respectively, and
wherein at least some of the third connection pads extend in a direction inclined with respect to the first direction and the second direction.

13. A method for manufacturing a display device according to any one of the preceding claims, comprising:
aligning the flexible printed circuit board on the display panel by adjusting a position of the first protrusion using a first alignment head and adjusting a position of the second protrusion using a second alignment head;
preliminarily pressing the display panel and the flexible printed circuit board; and
finally pressing the display panel and the flexible printed circuit board.

14. The method of claim 13, wherein, in the preliminarily pressing of the display panel and the flexible printed circuit board, the first connection pads and the first panel pads are preliminarily pressed using a first preliminary pressing head, and the second connection pads and the second panel pads are preliminarily pressed using a second preliminary pressing head different from the first preliminary pressing head.

15. The method of claim 13 or 14, wherein, in the finally pressing of the display panel and the flexible printed circuit board, the first connection pads and the first panel pads are finally pressed using a first final pressing head, and the second connection pads and the second panel pads are finally pressed using a second final pressing head different from the first final pressing head.
